# EUROPEAN PATENT SPECIFICATION

(11) **EP 3 760 758 B1**
(45) Date of publication and mention of the grant of the patent: **07.02.2024**
(21) Application number: 19775554.9
(22) Date of filing: 25.03.2019
(51) Int. Cl.: C23C 14/54, C23C 16/52, C23C 14/56, C23C 16/54, C23C 14/06, C23C 14/02, C23C 16/02, C23C 16/34, H01F 1/18

(54) **METHOD FOR PRODUCING GRAIN-ORIENTED ELECTRICAL STEEL SHEET AND CONTINUOUS FILM-FORMING DEVICE**
VERFAHREN ZUR HERSTELLUNG KORNORIENTIERTER ELEKTROBLECHE UND VORRICHTUNG ZUR KONTINUIERLICHEN FILMBILDUNG
PROCÉDÉ DE PRODUCTION D'UNE TÔLE D'ACIER ÉLECTRIQUE À GRAINS ORIENTÉS ET DISPOSITIF DE FORMATION DE FILM CONTINU

(30) Priority: 30.03.2018 JP 2018066457
(43) Date of publication of application: 06.01.2021
(73) Proprietor: JFE Steel Corporation, Tokyo 100-0011 (JP)
(72) Inventor: SHINGAKI, Yukihiro, Tokyo 100-0011 (JP); UMADA, Takumi, Tokyo 100-0011 (JP)
(74) Representative: Haseltine Lake Kempner LLP
(86) International application number: PCT/JP2019/012499
(87) International publication number: WO 2019/188976

(56) References cited:
- JP-A- S6 230 302
- JP-A- S6 230 302
- JP-A- S6 237 367
- JP-A- S6 250 459
- JP-A- S6 250 459
- JP-A- S6 269 505
- JP-A- H02 209 466
- JP-A- S60 103 133
- JP-A- S62 192 581
- JP-A- S63 105 960
- JP-A- 2005 089 810
- JP-B2- H0 649 901

## Description

### TECHNICAL FIELD

The present invention relates to a method of producing a grain oriented electrical steel sheet and a continuous coating formation apparatus.

### BACKGROUND ART

Grain oriented electrical steel sheets are soft magnetic materials used as materials for iron cores of transformers, generators and the like. Grain oriented electrical steel sheets are characterized in having a crystal structure in which the <001> orientation that is an easy magnetization axis of iron is highly-precisely aligned in the rolling direction of the steel sheet. The texture as above is formed through final annealing of a manufacturing process of a grain oriented electrical steel sheet, which final annealing allows crystal grains with the {110}<001> orientation referred to as the so-called Goss orientation to preferentially grow to an enormous size.

Grain oriented electrical steel sheets as products are required to have such magnetic properties as high magnetic flux density and low iron loss. Particularly in recent years, the demand for materials with low iron loss is increasing from the view point of energy saving.

Methods for achieving the lower iron loss include: the "higher orientation" technique which increases the integration of the {110}<001> orientation in the rolling direction; the "surface smoothing" technique with which a material surface is mirror-finished; the "magnetic domain refining" technique which involves a local strain or machining to a steel sheet surface; the "higher Si content" technique which raises the electrical resistance; the "thinning" technique which suppresses eddy current generation; and the "higher-tension coating" technique which applies tension stress in the rolling direction to a steel sheet.

Each of the techniques has been extensively studied and has already reached a high-level achievement.

In the meantime, the "higher-tension coating" technique is a technique which utilizes the difference in mechanical properties between a steel sheet and a coating on the steel sheet and has the steel sheet in a state of receiving tension stress in the rolling direction imparted by the coating.

In many cases, the coating having a different thermal expansion coefficient from that of the steel sheet is formed at high temperature and then cooled to room temperature. In this process, the steel sheet shrinks while being cooled, whereas the coating hardly varies in its shape, and hence tension stress can be applied to the steel sheet.

Accordingly, in general, the coating having a thermal expansion coefficient that is more largely different from that of the steel sheet can apply the larger tension to the steel sheet.

By forming such high-tension coating on a steel sheet having no forsterite coating and having under undergone surface smoothing, the effect of iron loss improvement is further enhanced.

Meanwhile, the difference in thermal expansion coefficient influences peeling resistance (adhesion property) between the steel sheet and the coating.

In a typical grain oriented electrical steel sheet, irregularities are formed at an interface between a steel sheet and a forsterite coating formed on the steel sheet to secure the peeling resistance (adhesion property) of the coating owing to the anchoring effect thereof.

However, when a coating having a different thermal expansion coefficient is formed on a smooth surface of a steel sheet having no forsterite coating, there is no benefit from their shapes, and the coating may sometimes peel off, for example, during the cooling process following the coating formation.

Therefore, methods for forming a coating having high peeling resistance have been conventionally studied. Examples thereof include a Physical Vapor Deposition (PVD) method of forming a ceramic coating of, for example, TiN, Tie or Ti(CN) with a physical means; and a Chemical Vapor Deposition (CVD) method of forming a coating with a chemical means.

These coating formation methods normally require a reduced pressure condition and also require uniform supply of a reaction gas to a steel sheet, and therefore it is difficult to continuously carry out coating formation by these methods. Hence, when these coating formation methods are adopted, a coating is often formed in the batch mode. However, the batch-mode coating formation may have a high production cost or may result in the inferior productivity. Accordingly, continuous coating formation apparatuses for continuously forming a coating using the above described coating formation methods have been conventionally proposed (Patent Literatures 1 to 2, for instance).

### CITATION LIST

### PATENT LITERATURES

Patent Literature 1: JP 62-040368 A
Patent Literature 2: JP 2005-089810 A

JP62050459 , JP6269505 , JP62030302 also disclose such coating deposition methods and apparatuses.

### SUMMARY OF INVENTION

### TECHNICAL PROBLEMS

The present inventors have studied the continuous coating formation apparatuses described in Patent Literatures 1 to 2 and found that the grain oriented electrical steel sheets produced by them have insufficient magnetic properties in some cases.

The present invention has been made in view of the above and aims at providing a method of producing a grain oriented electrical steel sheet that can produce a grain oriented electrical steel sheet having excellent magnetic properties.

The present invention also aims at providing a continuous coating formation apparatus to be used in the method of producing a grain oriented electrical steel sheet.

### SOLUTION TO PROBLEMS

The present inventors found, through an earnest study, that employing the configuration described below enables the achievement of the above-mentioned objectives, and the invention has been completed.

Specifically, the present invention is defined in the claims.

### ADVANTAGEOUS EFFECTS OF INVENTION

The present invention can provide a method of producing a grain oriented electrical steel sheet that can produce a grain oriented electrical steel sheet having excellent magnetic properties.

The present invention can also provide a continuous coating formation apparatus to be used in the method of producing a grain oriented electrical steel sheet.

### BRIEF DESCRIPTION OF DRAWINGS

[FIG. 1] FIG. 1 is a schematic view showing a continuous coating formation apparatus 1.
[FIG. 2] FIG. 2 is a graph showing a relationship between tension applied to a steel sheet and an iron loss value W_{17/50}.

### DESCRIPTION OF EMBODIMENTS

### [Findings Made by Inventors]

The present inventors have carefully studied grain oriented electrical steel sheets whose magnetic properties failed to reach the target value. As a result, it was found that many of the grain oriented electrical steel sheets whose magnetic properties failed to reach the target value showed a streak-like pattern in the width direction of the steel sheet. The present inventors further studied and, as a result, revealed that the steel sheets that showed the streak-like pattern had twins formed therein.

In ordinary grain oriented electrical steel sheets, twins may also be formed in the steel sheet structure and impair the magnetic properties. In this case, twins are often formed when the steel sheet receives a relatively large stress and is inevitably subjected to plastic deformation.

In this regard, the present inventors further advanced their study and discovered the following.

A grain oriented electrical steel sheet typically has a forsterite coating on a surface of a steel sheet. The forsterite coating has a higher Young's modulus than that of the steel sheet and is less likely to be deformed by compressive stress or tension stress. Thus, a grain oriented electrical steel sheet having no forsterite coating plastically deforms with a low stress value compared to a grain oriented electrical steel sheet having a forsterite coating.

Accordingly, it was found that a grain oriented electrical steel sheet having no forsterite coating may have a problem caused by stress that would not cause a problem to a grain oriented electrical steel sheet having a forsterite coating.

When a coating is continuously formed by the CVD method or the PVD method, a steel sheet is likely to be further strained to keep its flatness in order for the coating to be evenly formed. The present inventors assumed that the stress generated at this time would cause the formation of twins, and arrived at the idea of providing a continuous coating formation apparatus with a new mechanism for controlling tension in order to control the stress generated in the steel sheet.

Accordingly, the present inventors further studied a possible improvement in magnetic properties of a grain oriented electrical steel sheet by introducing the mechanism for controlling tension into a continuous coating formation apparatus.

In a grain oriented electrical steel sheet, the difference in thermal expansion coefficient between a steel sheet and a coating is used to cause high tension to be generated on the steel sheet, and the iron loss improvement effect owning to the tension leads to the better magnetic properties.

The foregoing effect is obtained through the mechanism described below. That is, since coating formation is carried out at high temperature, followed by the process of cooling to room temperature or other lower temperature, the steel sheet that has expanded during the coating formation shrinks due to cooling. On the contrary, a coating having a different thermal expansion coefficient does not vary in shape. Therefore, the steel sheet comes to be stretched by the coating. Such mechanism leads to the above-described effect.

Based on the mechanism, the present inventors made an intensive study. As a result, it was found that by applying tension to the steel sheet during coating formation, expansion of the steel sheet increases, and accordingly, the steel sheet can be brought into a state of being further stretched by the coating after the coating formation. In other words, it was found that the higher tension can be generated on the steel sheet after the coating formation.

Again, the present invention is described below.

### [Method of Producing Grain Oriented Electrical Steel Sheet]

The method of producing a grain oriented electrical steel sheet of the invention (hereinafter, also simply referred to as "production method of the invention") is a method of producing a grain oriented electrical steel sheet comprising performing coating formation treatment on a surface of a grain oriented electrical steel sheet having no forsterite coating, wherein the coating formation treatment is performed with tension being applied to the grain oriented electrical steel sheet having no forsterite coating.

### <Grain oriented electrical steel sheet having no forsterite coating>

Typically, a grain oriented electrical steel sheet having undergone a secondary recrystallization annealing called final annealing has a forsterite coating. On the contrary, in the production method of the invention, a grain oriented electrical steel sheet having no forsterite coating (hereinafter, also simply referred to as "steel sheet") is used. A surface of the steel sheet is preferably smooth.

The method of producing such a steel sheet is not particularly limited, and examples thereof include a method in which a forsterite coating is physically removed by mechanical polishing or another technique, and a surface of the steel sheet is chemically smoothed (see JP H09-118923 A, for example), and a method in which a chloride as an auxiliary agent is added in an annealing separator comprising MgO as a main component, and a forsterite coating is peeled after the final annealing (see JP 2002-363763 A and JP H08-269560 A, for example).

A method in which an annealing separator comprising alumina (Al₂ₐO₃), for example, is used so that a forsterite coating is not to be formed may also be employed. Use of two or more methods in combination is also efficient.

The obtained steel sheet preferably has a surface roughness of not more than 0.5 um in terms of Ra because the steel sheet on which a high tension coating is formed obtains more sufficient properties.

### <Coating formation treatment>

In the production method of the invention, coating formation treatment is performed on a surface of the grain oriented electrical steel sheet having no forsterite coating (steel sheet).

The steel sheet is, for example, in a strip shape elongated in one direction (rolling direction) and is preferably drawn from a coil to be conveyed. For instance, the coating formation treatment is continuously performed on the steel sheet that is being passed (conveyed) in a coating formation chamber of a continuous coating formation apparatus to be described later.

As the coating formation treatment, a Chemical Vapor Deposition (CVD) method or a Physical Vapor Deposition (PVD) method is employed.

A preferred CVD method is a thermal CVD method. The coating formation temperature is preferably from 900°C to 1100°C. While the coating formation pressure may be atmospheric pressure, a coating is preferably formed under a reduced pressure condition (including "vacuum condition") because the more even coating can be formed.

An example of the reduced pressure condition (internal pressure in the coating formation chamber) is 10 to 1000 Pa. However, since the CVD method is a method of forming a coating while supplying a reactive gas, the most suitable pressure varies depending on the composition of the coating to be formed, and hence the coating formation pressure cannot be uniquely determined.

A preferred PVD method is an ion plating method. The coating formation temperature is preferably 300°C to 600°C because the efficiency of coating formation can be increased. Since in the PVD method, a raw material called a target needs to be ionized and reach the steel sheet, the PVD method requires to be carried out under a reduced pressure condition that is lower than that for a CVD method. Specifically, a preferable example thereof is 0.1 to 100 Pa.

When the PVD method is employed, a bias voltage of - 10 to -300 V is preferably applied with the steel sheet serving as the cathode because the coating will have good adhesion. When plasma is used for ionization of the raw material, the coating formation rate can be increased.

It is preferable that the coating formed by the coating formation treatment has a different thermal expansion coefficient from (smaller thermal expansion coefficient than) that of the steel sheet and that deformation of the coating which occurs during application of stress is smaller than that of the steel sheet.

For the coating, specifically, a nitride coating is preferred, a metal nitride coating is more preferred, and a metal nitride coating including at least one metal selected from the group consisting of Zn, V, Cr, Mn, Fe, Co, Ni, Cu, Ti, Y, Nb, Mo, Hf, Zr, W and Ta is even more preferred. These coatings can easily have a rock salt structure, and since this structure easily matches the body-centered cubic lattice of the steel sheet (base iron), the adhesion of the coating can be improved.

The coating is not particularly limited to a single layer coating. For instance, the coating may be a multilayer and functional coating.

Through the coating formation treatment as above, a grain oriented electrical steel sheet having no forsterite coating and a grain oriented electrical steel sheet having a coating formed on its surface by the coating formation treatment can be obtained.

### <Tension application>

In the production method of the invention, a surface of a grain oriented electrical steel sheet having no forsterite coating (steel sheet) is subjected to the coating formation treatment as described above, and the coating formation treatment is performed with tension being applied by a roll to the steel sheet in, for example, one direction (such as the rolling direction). A tension measurement device measures a tension applied to the grain oriented electrical steel sheet having no forsterite coating and a tension controller controls driving of the roll based on a measurement result of the tension measurement device to maintain the tension applied to the grain oriented electrical steel sheet having no forsterite coating at a constant value.

In this manner, the obtained grain oriented electrical steel sheet can have excellent magnetic properties. The reason therefor should be because the expansion of the steel sheet during the coating formation treatment increases due to tension application to the steel sheet in the coating formation treatment, and as a result, the steel sheet comes to be further stretched by the coating, as described above.

The tension applied to the grain oriented electrical steel sheet having no forsterite coating (steel sheet) during the coating formation treatment (hereinafter, also simply referred to as "applied tension") is preferably not less than 0.10 MPa because it is sufficient to strain the steel sheet and allows the coating to be evenly formed without causing the steel sheet to be unstrained during coating formation or other problems. In order to improve the coating formation accuracy, the applied tension is more preferably not less than 0.50 MPa.

Meanwhile, the applied tension is preferably not more than 20.00 MPa because too large tension sometimes leads to generation of twins in the steel sheet to deteriorate the magnetic properties. When the coating is formed within the foregoing elastic deformation range, the effect of tension application by the coating is further improved, and good magnetic properties can be easily obtained, as compared to the case where the coating is formed with no tension being applied.

In other processes than the coating formation treatment, it is also preferable to control the tension applied to the steel sheet not to exceed 20.00 MPa for the similar reason.

Since the steel sheet is not always in a favorable shape, for example, an end portion of the steel sheet may have stress concentration so that the stress the steel sheet receives may locally exceeds the foregoing range. Such situation occurs depending on the shape of the steel sheet, and therefore there is no defined threshold value. Meanwhile, the applied tension is preferably not more than 10.00 MPa in view of the results of Examples to be described later, for example.

After the tension applied to the steel sheet is controlled to fall within the foregoing range during coating formation, tension exceeding the foregoing range may be applied to the steel sheet having undergone the coating formation. For example, when the coating formed on the steel sheet, as with a forsterite coating, has an effect of suppressing plastic deformation of the steel sheet, tension exceeding the foregoing range can be applied to the steel sheet having undergone the coating formation.

### <Pretreatment>

Prior to the coating formation treatment, it is preferable to carry out pretreatment to remove impurities such as oxides remaining on a surface of the steel sheet. Accordingly, the coating (e.g., a nitride coating) formed by the coating formation treatment has remarkably improved adhesion to the steel sheet (base iron).

Ion sputtering is a preferable example of the pretreatment method. In the case of ion sputtering, preferred examples of ion species to be used include ions of inert gases such as argon and nitrogen and ions of metals such as Ti and Cr.

The pretreatment is preferably carried out under a reduced pressure condition, and a preferable range thereof is 0.0001 to 1.0 Pa for the sake of increasing the mean free path of the sputtering ions.

A bias voltage of -50 to -1000 V is preferably applied with the steel sheet serving as the cathode.

For another example of the pretreatment method, a method using an electron beam is also known.

### <Additional treatment or process>

In order to ensure insulation quality, for example, an insulating coating may be additionally formed on the coating that has been formed by the coating formation treatment. The type of the insulating coating is not particularly limited, and a conventionally known insulating coating can be formed. Examples of the method for forming the insulating coating include the methods described in JP 50-79442 A and JP 48-39338 A, in which a coating liquid containing phosphate-chromic acid-colloidal silica is coated on the coating that has been formed by the coating formation treatment, followed by baking at about 800°C.

The shape of the steel sheet can be corrected by flattening annealing, and in addition, the flattening annealing may be carried out to also serve as baking of the insulating coating.

### [Continuous coating formation apparatus]

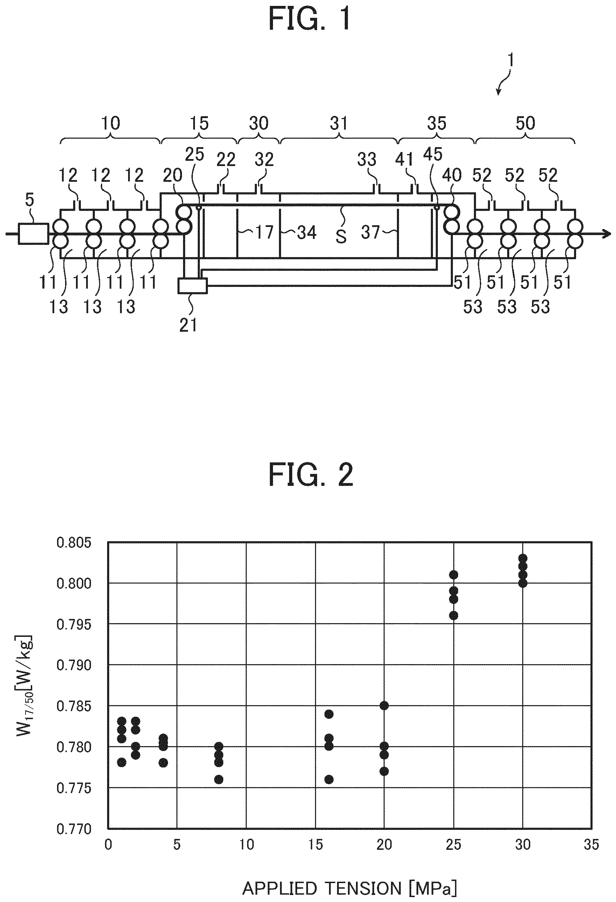

Next, an example of the continuous coating formation apparatus of the present invention to be suitably used in the foregoing production method of the invention is described with reference to FIG. 1.

### <Basic configuration>

FIG. 1 is a schematic view showing a continuous coating formation apparatus 1. First, the basic configuration of the continuous coating formation apparatus 1 of FIG. 1 is described. A coating formation-target material S is conveyed from left to right in FIG. 1. An example of the coating formation-target material S is a grain oriented electrical steel sheet having no forsterite coating as described above. An example of the conveying direction is a direction along the rolling direction.

The continuous coating formation apparatus 1 includes a coating formation chamber 31. The coating formation chamber 31 is provided with an exhaust port 33. Internal gas of the coating formation chamber 31 is discharged through the exhaust port 33, whereby a reduced pressure condition is achieved.

The conveyed coating formation-target material S is passed through the coating formation chamber 31. The coating formation chamber 31 continuously performs coating formation on the coating formation-target material S that is being passed therethrough. A preferable coating formation treatment is the coating formation treatment described in connection with the production method of the invention, and the CVD method or the PVD method may be suitably employed. In this case, the coating formation chamber 31 is supplied with a raw material gas (atmospheric gas) such as nitrogen gas or TiCl₄ gas for coating formation.

A decompression chamber 15 situated on an upstream side of the coating formation chamber 31 is provided with a bridle roll 20. A decompression chamber 35 situated on a downstream side of the coating formation chamber 31 is provided with a bridle roll 40. The bridle rolls 20 and 40 are used to apply tension to the coating formation-target material S in the coating formation chamber 31.

The bridle rolls 20 and 40 are connected to a tension controller 21 disposed on an outside of the coating formation chamber 31. The bridle rolls 20 and 40 are driven under control of the tension controller 21 and apply tension to the coating formation-target material S being passed through the coating formation chamber 31.

In the meantime, when the bridle rolls 20 and 40 are disposed inside the coating formation chamber 31, a coating may be formed on surfaces of the rolls by the coating formation treatment. In that case, there may be a problem that the rolls are unevenly weighted to make the tension control difficult or that the coating formation-target material S meanders. Accordingly, the bridle rolls 20 and 40 are each preferably separated from the coating formation chamber 31 by a boundary wall.

Specifically, in FIG. 1, the bridle roll 20 is disposed in the decompression chamber 15 that is separated from the coating formation chamber 31 by a boundary wall 17 while the bridle roll 40 is disposed in the decompression chamber 35 that is separated from the coating formation chamber 31 by a boundary wall 37.

The decompression chamber 15 and the decompression chamber 35 are provided with a tension measurement device 25 and a tension measurement device 45, respectively. The tension measurement devices 25 and 45 are used to measure the tension applied to the coating formation-target material S in the coating formation chamber 31. The tension measurement devices 25 and 45 are connected to the tension controller 21, and the measurement results are input to the tension controller 21.

The tension controller 21 controls the driving of the bridle rolls 20 and 40 based on the measurement results input from the tension measurement devices 25 and 45 to thereby maintain the tension applied to the coating formation-target material S in the coating formation chamber 31 at a constant value.

In this manner, the coating formation-target material S being passed through the coating formation chamber 31 is subjected to the coating formation treatment while receiving the tension in a longitudinal direction.

For the above described reason, the tension to be applied to the coating formation-target material S in the coating formation chamber 31 is preferably not less than 0.10 MPa and not more than 20.00 MPa and more preferably not less than 0.50 MPa and not more than 10.00 MPa.

### <Other configuration>

Other configuration of the continuous coating formation apparatus 1 of FIG. 1 is to be described.

As shown in FIG. 1, a pretreatment chamber 30 for performing the foregoing pretreatment is preferably disposed on an upstream side of the coating formation chamber 31. The pretreatment chamber 30 is provided with an exhaust port 32 to achieve a reduced pressure condition. The pretreatment chamber 30 and the coating formation chamber 31 are separated from each other by a boundary wall 34.

When the pretreatment in the pretreatment chamber 30 and the coating formation treatment in the coating formation chamber 31 are carried out under a reduced pressure condition, a differential pressure area having at least one differential pressure chamber is preferably provided so as to reduce the internal pressure (degree of vacuum) stepwise.

In this case, when the decompression chambers 15 and 35 are provided as in the continuous coating formation apparatus 1 shown in FIG. 1, the differential pressure area is more preferably provided on each of the entry side of the decompression chamber 15 and the exit side of the decompression chamber 35.

Specifically, in FIG. 1, an entry differential pressure area 10 comprising three entry differential pressure chambers 13 is provided on the entry side of the decompression chamber 15. Meanwhile, the number of the entry differential pressure chambers 13 is not limited to three.

Each of the entry differential pressure chambers 13 is provided with an exhaust port 12. An amount of gas to be discharged through the exhaust port 12 is increased stepwise as the entry differential pressure chamber 13 is closer to the pretreatment chamber 30 and the coating formation chamber 31. With this configuration, the internal pressure in the entry differential pressure chambers 13 constituting the entry differential pressure area 10 is reduced stepwise toward the pretreatment chamber 30 and the coating formation chamber 31. Thus, the internal pressure of the entry differential pressure area 10 approaches the internal pressure in the pretreatment chamber 30 and the coating formation chamber 31 from the atmospheric pressure.

An exit differential pressure area 50 has the same configuration as that of the entry differential pressure area 10. That is, in FIG. 1, the exit differential pressure area 50 comprising three exit differential pressure chambers 53 is provided on the exit side of the decompression chamber 35. Meanwhile, the number of the exit differential pressure chambers 53 is not limited to three.

Each of the exit differential pressure chambers 53 is provided with an exhaust port 52. An amount of gas to be discharged through the exhaust port 52 is decreased stepwise as the exit differential pressure chamber 53 is separated farther from the pretreatment chamber 30 and the coating formation chamber 31. With this configuration, the internal pressure in the exit differential pressure chambers 53 constituting the exit differential pressure area 50 is increased stepwise as the exit differential pressure chamber 53 is separated farther from the pretreatment chamber 30 and the coating formation chamber 31. Accordingly, the internal pressure in the exit differential pressure area 50 approaches the atmospheric pressure from the internal pressure of the pretreatment chamber 30 and the coating formation chamber 31.

While the entry differential pressure area 10 and the exit differential pressure area 50 respectively have seal rolls 11 and seal rolls 51, each of which is disposed between the neighboring differential chambers or other chambers, the invention is not limited thereto as long as a pressure difference can be attained between neighboring chambers.

Since the grain oriented electrical steel sheet is held in a coil form for a long period of time for final annealing, a lower end portion of the coil is sometimes bent or deformed. A problem may arise where the deformed end portion of the coating formation-target material S damages the bridle roll or other components when being passed therethrough. In order to prevent such problem, a shear for cutting off an end portion of the coating formation-target material S is preferably provided on an upstream side of the entry differential pressure area 10.

### EXAMPLES

The present invention is specifically described below with reference to examples. However, the present invention should not be construed as being limited to the following examples.

### <Test Example 1>

A primary recrystallized sheet with a sheet thickness of 0.23 mm subjected to the magnetic domain refining through groove machining by etching was coated with Al₂O₃ as an annealing separator when the secondary recrystallization annealing was carried out, whereby a grain oriented electrical steel sheet having no forsterite coating (steel sheet) was obtained. The obtained steel sheet was subjected to a coating formation experiment with tension being applied thereto using a laboratory CVD apparatus.

More specifically, a specimen with a size of 300 mm in the rolling direction and 50 mm in the direction perpendicular to the rolling direction was cut out from the obtained steel sheet and was placed as a sample in the laboratory CVD apparatus. In this process, a weight was attached to one side of the sample to achieve the situation where tension was constantly applied to the steel sheet in the rolling direction, and the coating formation treatment was carried out. By varying the weight attached to the sample, the coating formation treatment was carried out under various tension conditions.

The CVD method was used as the coating formation treatment. The internal pressure in a furnace during the coating formation treatment was set to 860 Pa, the furnace temperature was raised to 1000°C, and a TiCl₄-N₂-H₂ mixture gas was introduced into the furnace to perform the coating formation treatment for five minutes. The temperature was lowered after the coating formation, and the sample was taken out. On a surface of the sample thus taken out, a TiN coating with a thickness of 0.8 um was formed.

The steel sheet on which the TiN coating had been formed was visually checked to determine whether the surface had a stripe pattern. Thereafter, the sample was coated with a phosphate-based coating liquid and baked at 850°C for 60 seconds to have an insulating coating formed thereon, whereby a test material of a grain oriented electrical steel sheet comprising a steel sheet, a TiN coating and an insulating coating was obtained.

The obtained test material of the grain oriented electrical steel sheet was excited to 1.7 T at a frequency of 50 Hz, and the iron loss value W_{17/50} (unit: W/Kg) was measured. The magnetism measurement was carried out using a single sheet tester (SST). The results are plotted on a graph in FIG. 2.

FIG. 2 is a graph showing a relationship between the tension applied to a steel sheet and an iron loss value W_{17/50}. The graph of FIG. 2 reveals that the magnetic properties tended to be more excellent when the applied tension was not more than 20.00 MPa than when the applied tension exceeded 20.00 MPa.

The test material with the applied tension exceeding 20.00 MPa showed a stripe pattern in some cases, while no stripe pattern was seen on the test material with the applied tension not more than 20.00 MPa.

### <Test Example 2>

A grain oriented electrical steel sheet from which a forsterite coating was removed by grinding and which had a surface roughness value Ra shown in Table 1 with a sheet thickness of 0.21 mm was treated as the coating formation-target material S and was passed through the continuous coating formation apparatus 1 of FIG. 1. With the bridle rolls 20 and 40 being controlled, the tension applied to the coating formation-target material S (steel sheet) being passed through the coating formation chamber 31 was maintained within the range (0.05 MPa to 350.00 MPa) shown in Table 1 below. The PVD method was performed as the coating formation treatment in the coating formation chamber 31, and a CrN coating with a thickness of 1.0 um was formed.

In the pretreatment chamber 30, the pretreatment for removing oxides from a surface of the steel sheet was carried out using Ar ions accelerated by -600V bias voltage. Subsequently, in the coating formation chamber 31, the coating formation treatment was carried out with the steel sheet serving as the cathode under the conditions of the bias voltage: -100V and the coating formation rate: 1.0 nm/s. The steel sheet temperature at the time of coating formation was 500°C.

Following the coating formation in the continuous coating formation apparatus 1, a phosphate-based coating liquid was coated on a CrN coating and was then baked at 850°C for 60 seconds, whereby an insulating coating was formed. After the insulating coating was formed, the magnetic domain refining was performed on the steel sheet by irradiation with an electron beam.

Accordingly, a test material of a grain oriented electrical steel sheet comprising a steel sheet, a CrN coating and an insulating coating and having undergone the magnetic domain refining was obtained.

### <<Coating Adhesion Property (Bending-Peeling Diameter)>>

The coating adhesion property of the obtained test material of the grain oriented electrical steel sheet was evaluated using a round bar winding method. Specifically, a specimen (280 mm in rolling direction x 30 mm in direction perpendicular to rolling direction in length) was wound around a round bar having a diameter of 80 mm and was then wound 180° reversely, and presence of cracks or pealing of the coating was visually checked. Similar evaluations were conducted with the diameter of the round bar being decreased by 5 mm each time, and the coating adhesion property was evaluated based on the minimum diameter (bending-peeling diameter) with which no visible crack or peeling had occurred.

The smaller value of the bending-peeling diameter can be evaluated as having excellent coating adhesion, and when the bending-peeling diameter is not more than 30 mm, it can be evaluated as having particularly excellent coating adhesion property. The results are shown in Table 1 below.

### <<Magnetic Property (Average W_{17/50} and Maximum W_{17/50}) >>

The obtained test material of the grain oriented electrical steel sheet was excited to 1.7 T at a frequency of 50 Hz, the iron loss value W_{17/50} (unit: W/Kg) was measured, and the magnetic property was evaluated.

Specifically, first, five different locations on the obtained grain oriented electrical steel sheet in the longitudinal direction (rolling direction) were randomly determined. A strip specimen having lengths of 100 mm in the direction perpendicular to the rolling direction and 320 mm in the rolling direction was cut out from the steel sheet at each of the determined locations. In this process, a plurality of specimens were cut out at each of the determined locations from one end to the other end in the direction perpendicular to the rolling direction. The specimens totaled 55 pieces. The magnetism measurement was carried out on each of the specimens using a single sheet tester (SST) . The average iron loss value (Average W_{17/50}) and the maximum iron loss value (Maximum W_{17/50}) of the 55 specimens were found. The results are shown in Table 1 below.

### [Table 1]

**Table 1**

| Test Material No. | Surface roughness Ra [*µ*m] | Applied tension [MPa] | Bending-peeling diameter [mm*φ*] | Average W_{17/50} [W/kg] | Maximum W_{17/50} [W/kg] |
|---|---|---|---|---|---|
| 1 | 0.1 | 0.05 | 60 | 0.712 | 0.728 |
| 2 | | 0.10 | 30 | 0.688 | 0.699 |
| 3 | | 0.50 | 15 | 0.674 | 0.686 |
| 4 | | 1.00 | 15 | 0.677 | 0.685 |
| 5 | | 2.00 | 10 | 0.672 | 0.684 |
| 6 | | 5.00 | 20 | 0.675 | 0.685 |
| 7 | | 7.50 | 10 | 0.672 | 0.681 |
| 8 | | 10.00 | 20 | 0.678 | 0.689 |
| 9 | | 15.00 | 15 | 0.682 | 0.701 |
| 10 | | 20.00 | 15 | 0.681 | 0.700 |
| 11 | | 25.00 | 25 | 0.699 | 0.726 |
| 12 | | 30.00 | 25 | 0.701 | 0.728 |
| 13 | | 35.00 | 30 | 0.702 | 0.727 |
| 14 | 0.3 | 0.05 | 50 | 0.714 | 0.731 |
| 15 | | 5.00 | 15 | 0.678 | 0.687 |
| 16 | | 10.00 | 15 | 0.682 | 0.691 |
| 17 | | 20.00 | 10 | 0.684 | 0.702 |
| 18 | | 30.00 | 25 | 0.703 | 0.732 |
| 19 | 0.5 | 0.10 | 25 | 0.692 | 0.702 |
| 20 | | 0.50 | 15 | 0.677 | 0.689 |
| 21 | | 1.00 | 10 | 0.680 | 0.689 |
| 22 | | 2.00 | 10 | 0.676 | 0.687 |
| 23 | | 5.00 | 15 | 0.679 | 0.690 |

In Table 1 above, Test Materials Nos. 1 to 13 (surface roughness Ra: 0.1 µm) are compared with each other. Test Materials Nos. 2 to 10 each having the applied tension within the range of 0.10 to 20.00 MPa exhibited the more excellent magnetic properties (Average W_{17/50} and Maximum W_{17/50}), and Test Materials Nos. 3 to 8 each having the applied tension within the range of 0.50 to 10.00 MPa exhibited even more excellent magnetic properties.

Here, Test Materials Nos. 2 to 10 are compared with each other. When the applied tension is not more than 10.00 MPa, the difference between Average W_{17/50} and Maximum W_{17/50} is small (Maximum W_{17/50} is small as compared to Average W₁₇/₅₀), which indicates that local deterioration in magnetic properties may be suppressed.

The foregoing tendency was seen also in other Test Materials having different surface roughness Ra.

Test Materials Nos. 14 to 18 (surface roughness Ra: 0.3 µm) are to be reviewed. For instance, Test Materials Nos. 15 to 17 each having the applied tension within the range of 0.10 to 20.00 MPa exhibited the more excellent magnetic properties, and Test Materials Nos. 15 to 16 each having the applied tension within the range of 0.50 to 10.00 MPa exhibited even more excellent magnetic properties.

Test Materials Nos. 19 to 23 (surface roughness Ra: 0.50 µm) each had the applied tension falling within the range of 0.10 to 20.00 MPa and exhibited good magnetic properties. Test Materials Nos. 20 to 23 each having the applied tension within the range of 0.50 to 10.00 MPa exhibited the better magnetic properties.

Comparison of Test Materials Nos. 1 to 23 revealed that when the applied tension is not less than 0.10 MPa (Test Materials except Test Materials Nos. 1 and 14), the bending-peeling diameter does not exceed 30 mm, and the coating adhesion properties are excellent.

### REFERENCE SIGNS LIST

- 1:: continuous coating formation apparatus
- 5:: shear
- 10:: entry differential pressure area
- 11:: seal roll
- 12:: exhaust port
- 13:: entry differential pressure chamber
- 15:: decompression chamber
- 17:: boundary wall
- 20:: bridle roll (roll)
- 21:: tension controller
- 22:: exhaust port
- 25:: tension measurement device
- 30:: pretreatment chamber
- 31:: coating formation chamber
- 32:: exhaust port
- 34:: boundary wall
- 35:: decompression chamber
- 37:: boundary wall
- 40:: bridle roll (roll)
- 41:: exhaust port
- 45:: tension measurement device
- 50:: exit differential pressure area
- 51:: seal roll
- 52:: exhaust port
- 53:: exit differential pressure chamber
- S:: coating formation-target material

## Claims

1. A method of producing a grain oriented electrical steel sheet, the method comprising performing coating formation treatment on a surface of a grain oriented electrical steel sheet (S) having no forsterite coating,
wherein the coating formation treatment is performed with tension being applied by a roll (20, 40) to the grain oriented electrical steel sheet having no forsterite coating,
wherein a tension measurement device (25, 45) measures a tension applied to the grain oriented electrical steel sheet (S) having no forsterite coating,
wherein a tension controller (21) controls driving of the roll (20, 40) based on a measurement result of the tension measurement device (25, 45) to maintain the tension applied to the grain oriented electrical steel sheet (S) having no forsterite coating at a constant value, and
wherein the coating formation treatment is carried out by a chemical vapor deposition method or a physical vapor deposition method.

2. The method of producing a grain oriented electrical steel sheet according to claim 1, wherein the tension applied to the grain oriented electrical steel sheet (S) having no forsterite coating is not less than 0.10 MPa and not more than 20.00 MPa.

3. The method of producing a grain oriented electrical steel sheet according to claim 1, wherein the tension applied to the grain oriented electrical steel sheet (S) having no forsterite coating is not less than 0.50 MPa and not more than 10.00 MPa.

4. The method of producing a grain oriented electrical steel sheet according to claim 1, wherein the coating formation treatment is carried out under a reduced pressure condition.

5. A continuous coating formation apparatus (1) comprising:
a PVD or CVD coating formation chamber (31) for continuously performing coating formation treatment on a coating formation-target material (S) being conveyed;
a roll (20, 40) disposed on each of an upstream side and a downstream side of the coating formation chamber (31) and used to apply tension to the coating formation-target material (S) in the coating formation chamber (31);
a tension measurement device (25, 45) for measuring the tension applied to the coating formation-target material (S) in the coating formation chamber (31); and
a tension controller (21) for controlling driving of the roll (20, 40) based on a measurement result of the tension measurement device (25, 45) to maintain the tension applied to the coating formation-target material (S) in the coating formation chamber (31) at a constant value.

6. The continuous coating formation apparatus (1) according to claim 5, wherein the coating formation-target material (S) is a grain oriented electrical steel sheet (S) having no forsterite coating.

7. The continuous coating formation apparatus (1) according to claim 5 or 6, wherein the tension applied to the coating formation-target material (S) in the coating formation chamber (31) is not less than 0.10 MPa and not more than 20.00 MPa.

8. The continuous coating formation apparatus (1) according to claim 5 or 6, wherein the tension applied to the coating formation-target material (S) in the coating formation chamber (31) is not less than 0.50 MPa and not more than 10.00 MPa.

9. The continuous coating formation apparatus (1) according to any one of claims 5 to 8, wherein the coating formation chamber (31) performs the coating formation treatment by a chemical vapor deposition method or a physical vapor deposition method.

10. The continuous coating formation apparatus (1) according to any one of claims 5 to 9, wherein a differential pressure area (10, 50) is disposed on each of an upstream side and a downstream side of the coating formation chamber (31).

11. The continuous coating formation apparatus (1) according to any one of claims 5 to 10, wherein the roll (20, 40) is separated from the coating formation chamber (31) by a boundary wall (34, 37).

12. The continuous coating formation apparatus (1) according to any one of claims 5 to 11, wherein a shear (5) for cutting off an end portion of the coating formation-target material (S) is disposed on an upstream side of the coating formation chamber (31).

## Patentansprüche

1. Verfahren zum Herstellen eines kornorientierten Elektrostahlblechs, wobei das Verfahren Durchführen einer Beschichtungsbildungsbehandlung auf einer Oberfläche eines kornorientierten Elektrostahlblechs (S), das keine Forsteritbeschichtung aufweist, umfasst,
wobei die Beschichtungsbildungsbehandlung unter Spannung durchgeführt wird, die von einer Walze (20, 40) auf das kornorientierte Elektrostahlblech aufgebracht wird, das keine Forsteritbeschichtung aufweist,
wobei eine Spannungsmessvorrichtung (25, 45) eine auf das kornorientierte Elektrostahlblech (S), das keine Forsteritbeschichtung aufweist, aufgebrachte Spannung misst,
wobei ein Spannungsregler (21) den Antrieb der Walze (20, 40) basierend auf einem Messergebnis der Spannungsmessvorrichtung (25, 45) regelt, um die auf das kornorientierte Elektrostahlblech (S), das keine Forsteritbeschichtung aufweist, aufgebrachte Spannung auf einem konstanten Wert zu halten, und
wobei die Beschichtungsbildungsbehandlung durch ein Verfahren zur chemischen Gasphasenabscheidung oder ein Verfahren zur physikalischen Gasphasenabscheidung ausgeführt wird.

2. Verfahren zum Herstellen eines kornorientierten Elektrostahlblechs nach Anspruch 1, wobei die auf das kornorientierte Elektrostahlblech (S), das keine Forsteritbeschichtung aufweist, aufgebrachte Spannung, nicht weniger als 0,10 MPa und nicht mehr als 20,00 MPa beträgt.

3. Verfahren zum Herstellen eines kornorientierten Elektrostahlblechs nach Anspruch 1, wobei die auf das kornorientierte Elektrostahlblech (S), das keine Forsteritbeschichtung aufweist, aufgebrachte Spannung, nicht weniger als 0,50 MPa und nicht mehr als 10,00 MPa beträgt.

4. Verfahren zum Herstellen eines kornorientierten Elektrostahlblechs nach Anspruch 1, wobei die Beschichtungsbildungsbehandlung unter Bedingungen verminderten Drucks ausgeführt wird.

5. Apparatur (1) zur kontinuierlichen Beschichtungsbildung, umfassend:
eine PVD- oder CVD-Beschichtungsbildungskammer (31) zum kontinuierlichen Durchführen einer Beschichtungsbildungsbehandlung an einem geförderten Beschichtungsbildungs-Zielmaterial (S);
eine Walze (20, 40), die jeweils auf einer stromaufwärtigen und einer stromabwärtigen Seite der Beschichtungsbildungskammer (31) angeordnet ist und dazu verwendet wird, Spannung auf das Beschichtungsbildungs-Zielmaterial (S) in der Beschichtungsbildungskammer (31) aufzubringen;
eine Spannungsmessvorrichtung (25, 45) zum Messen der auf das Beschichtungsbildungs-Zielmaterial (S) in der Beschichtungsbildungskammer (31) aufgebrachten Spannung; und
einen Spannungsregler (21) zum Regeln des Antriebs der Walze (20, 40) basierend auf einem Messergebnis der Spannungsmesseinrichtung (25, 45), um die auf das Beschichtungsbildungs-Zielmaterial (S) in der Beschichtungsbildungskammer (31) aufgebrachte Spannung auf einem konstanten Wert zu halten.

6. Apparatur (1) zur kontinuierlichen Beschichtungsbildung nach Anspruch 5, wobei das Beschichtungsbildungs-Zielmaterial (S) ein kornorientiertes Elektrostahlblech (S) ist, das keine Forsteritbeschichtung aufweist.

7. Apparatur (1) zur kontinuierlichen Beschichtungsbildung nach Anspruch 5 oder 6, wobei die auf das Beschichtungsbildungs-Zielmaterial (S) in der Beschichtungsbildungskammer (31) aufgebrachte Spannung nicht weniger als 0,10 MPa und nicht mehr als 20,00 MPa beträgt.

8. Apparatur (1) zur kontinuierlichen Beschichtungsbildung nach Anspruch 5 oder 6, wobei die auf das Beschichtungsbildungs-Zielmaterial (S) in der Beschichtungsbildungskammer (31) aufgebrachte Spannung nicht weniger als 0,50 MPa und nicht mehr als 10,00 MPa beträgt.

9. Apparatur (1) zur kontinuierlichen Beschichtungsbildung nach einem der Ansprüche 5 bis 8, wobei die Beschichtungsbildungskammer (31) die Beschichtungsbildungsbehandlung durch ein Verfahren zur chemischen Gasphasenabscheidung oder ein Verfahren zur physikalischen Gasphasenabscheidung durchführt.

10. Apparatur (1) zur kontinuierlichen Beschichtungsbildung nach einem der Ansprüche 5 bis 9, wobei ein Differenzdruckbereich (10, 50) auf jeweils einer stromaufwärtigen Seite und einer stromabwärtigen Seite der Beschichtungsbildungskammer (31) angeordnet ist.

11. Apparatur (1) zur kontinuierlichen Beschichtungsbildung nach einem der Ansprüche 5 bis 10, wobei die Walze (20, 40) von der Beschichtungsbildungskammer (31) durch eine Begrenzungswand (34, 37) getrennt ist.

12. Apparatur (1) zur kontinuierlichen Beschichtungsbildung nach einem der Ansprüche 5 bis 11, wobei eine Schere (5) zum Abschneiden eines Endabschnitts des Beschichtungsbildungs-Zielmaterials (S) auf einer stromaufwärtigen Seite der Beschichtungsbildungskammer (31) angeordnet ist.

## Revendications

1. Procédé de production d'une tôle d'acier électrique à grains orientés, le procédé comprenant la réalisation d'un traitement de formation de revêtement sur une surface d'une tôle d'acier électrique à grains orientés (S) dépourvue de revêtement de forstérite,
dans lequel le traitement de formation de revêtement est réalisé au moyen d'une tension appliquée par un rouleau (20, 40) à la tôle d'acier électrique à grains orientés dépourvue de revêtement de forstérite,
dans lequel un dispositif de mesure de tension (25, 45) mesure une tension appliquée à la tôle d'acier électrique à grains orientés (S) dépourvue de revêtement de forstérite,
dans lequel un dispositif de commande de tension (21) commande l'entraînement du rouleau (20, 40) sur la base d'un résultat de mesure du dispositif de mesure de tension (25, 45) pour maintenir la tension appliquée à la tôle d'acier électrique à grains orientés (S) dépourvue de revêtement de forstérite à une valeur constante, et
dans lequel le traitement de formation de revêtement est réalisé par un procédé de dépôt chimique en phase vapeur ou un procédé de dépôt physique en phase vapeur.

2. Procédé de production d'une tôle d'acier électrique à grains orientés selon la revendication 1, dans lequel la tension appliquée à la tôle d'acier électrique à grains orientés (S) dépourvue de revêtement de forstérite n'est pas inférieure à 0,10 MPa et n'est pas supérieure à 20,00 MPa.

3. Procédé de production d'une tôle d'acier électrique à grains orientés selon la revendication 1, dans lequel la tension appliquée à la tôle d'acier électrique à grains orientés (S) dépourvue de revêtement de forstérite n'est pas inférieure à 0,50 MPa et n'est pas supérieure à 10,00 MPa.

4. Procédé de production d'une tôle d'acier électrique à grains orientés selon la revendication 1, dans lequel le traitement de formation de revêtement est réalisé sous pression réduite.

5. Appareil de formation de revêtement en continu (1) comprenant :
une chambre de formation de revêtement PVD ou CVD (31) pour réaliser un traitement de formation de revêtement en continu sur un matériau cible de formation de revêtement (S) transporté ;
un rouleau (20, 40) disposé sur chacun d'un côté amont et d'un côté aval de la chambre de formation de revêtement (31) et utilisé pour appliquer une tension au matériau cible de formation de revêtement (S) dans la chambre de formation de revêtement (31) ;
un dispositif de mesure de tension (25, 45) pour mesurer la tension appliquée au matériau cible de formation de revêtement (S) dans la chambre de formation de revêtement (31) ; et
un dispositif de commande de tension (21) destiné à commander l'entraînement du rouleau (20, 40) sur la base d'un résultat de mesure du dispositif de mesure de tension (25, 45) afin de maintenir la tension appliquée au matériau cible de formation de revêtement (S) dans la chambre de formation de revêtement (31) à une valeur constante.

6. Appareil de formation de revêtement en continu (1) selon la revendication 5, dans lequel le matériau cible de formation de revêtement (S) est une tôle d'acier électrique à grains orientés (S) dépourvue de revêtement de forstérite.

7. Appareil de formation de revêtement en continu (1) selon la revendication 5 ou 6, dans lequel la tension appliquée au matériau cible de formation de revêtement (S) dans la chambre de formation de revêtement (31) n'est pas inférieure à 0,10 MPa et n'est pas supérieure à 20,00 MPa.

8. Appareil de formation de revêtement en continu (1) selon la revendication 5 ou 6, dans lequel la tension appliquée au matériau cible de formation de revêtement (S) dans la chambre de formation de revêtement (31) n'est pas inférieure à 0,50 MPa et n'est pas supérieure à 10,00 MPa.

9. Appareil de formation de revêtement en continu (1) selon l'une quelconque des revendications 5 à 8, dans lequel la chambre de formation de revêtement (31) réalise le traitement de formation de revêtement par un procédé de dépôt chimique en phase vapeur ou un procédé de dépôt physique en phase vapeur.

10. Appareil de formation de revêtement en continu (1) selon l'une quelconque des revendications 5 à 9, dans lequel une zone de pression différentielle (10, 50) est disposée sur chacun d'un côté amont et d'un côté aval de la chambre de formation de revêtement (31).

11. Appareil de formation de revêtement en continu (1) selon l'une quelconque des revendications 5 à 10, dans lequel le rouleau (20, 40) est séparé de la chambre de formation de revêtement (31) par une paroi de délimitation (34, 37).

12. Appareil de formation de revêtement en continu (1) selon l'une quelconque des revendications 5 à 11, dans lequel une cisaille (5) pour découper une partie d'extrémité du matériau cible de formation de revêtement (S) est disposée sur un côté amont de la chambre de formation de revêtement (31).
